Europäisches Patentamt

European Patent Office

Office européen des brevets

(19)

(11) Publication number: 0 196 616
A2

(12) EUROPEAN PATENT APPLICATION

(21) Application number: 86104152.3

(22) Date of filing: 26.03.86

(51) Int. Cl.⁴: H 03 K 19/094

(30) Priority: 28.03.85 JP 62094/85

(43) Date of publication of application:
08.10.86 Bulletin 86/41

(84) Designated Contracting States:
DE FR GB

(71) Applicant: Kabushiki Kaisha Toshiba
72, Horikawa-cho Saiwai-ku
Kawasaki-shi Kanagawa-ken 210(JP)

(72) Inventor: Sugiyama, Hisashi
2-14-1 Ookubo Kounan-ku
Yokohama-shi Kanagawa-ken(JP)

(72) Inventor: Mizoguchi, Satoshi
2-14-1 Ookubo Kounan-ku
Yokohama-shi Kanagawa-ken(JP)

(72) Inventor: Sugimoto, Yasuhiro
2-12-10-403 Namiki Kanazawa-ku
Yokohama-shi Kanagawa-ken(JP)

(74) Representative: Lehn, Werner, Dipl.-Ing. et al,
Hoffmann, Eitle & Partner Patentanwälte Arabellastrasse
4 (Sternhaus)
D-8000 München 81(DE)

(54) Logic circuit.

(57) A logic circuit in accordance with the present invention comprises a first inverter circuit (22) for inverting a signal that is inputted to its input terminal; a second inverter circuit (24) for inverting the signal that is inverted by said first inverter circuit; a first type first bipolar transistor (42) whose base is connected to either of said first inverter circuit and said second inversion circuit, whose collector is connected to a first power supply terminal (32), and whose emitter is connected to the output terminal of the logic circuit; and a first type second bipolar transistor (44) whose base is connected to the other of the first inversion circuit and the second inverter circuit, whose collector is connected to the output terminal, and whose emitter is connected to a second power supply terminal (34).

FIG. 2

## LOGIC CIRCUIT

## 1 BACKGROUND OF THE INVENTION

### Field of the Invention

The present invention relates to a logic circuit which allows to improve the high-speed operational capability of the load that is connected to its output.

### Description of the Prior Art

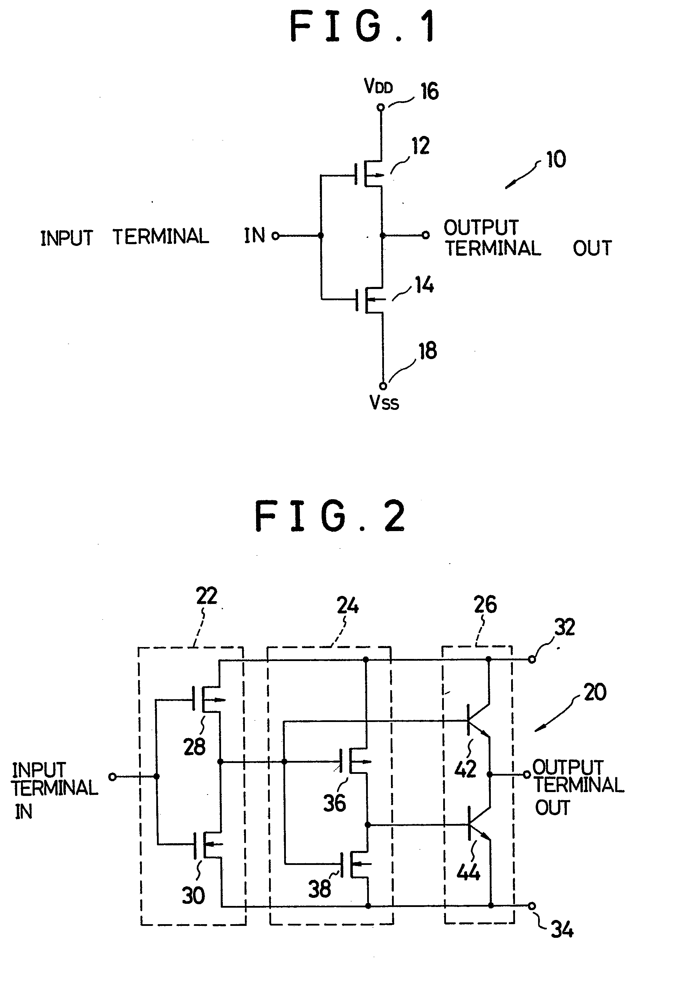

Referring to Fig. 1, a prior example of the inverter circuit comprised of a CMOS is shown with reference numeral 10. The inverter circuit 10 is composed of a P-channel MOS transistor (referred to as "PMOS" hereafter) 12 and an N-channel MOS transistor (referred to as "NMOS" hereafter) 14. In addition to that the gate terminals of the PMOS 12 and the NMOS 14 are connected to the input terminal IN that receives a signal to be inverted, their respective drain terminals are connected to the output terminal OUT that outputs the signal inverted. The source terminal of the PMOS 12 is connected to a voltage source $V_{DD}$ 16, and the source terminal of the NMOS 14 is connected to a $V_{SS}$ terminal that supplies, for example, a potential of OV.

When a high-level signal is input to the IN terminal of an inverter circuit as described in the above, the PMOS 12 assumes an off-state while the NMOS 14 takes on an on-state, so that there will be output a low-level signal from the output terminal OUT. On the contrary, if a low-level signal is input to the IN terminal, the PMOS 12 becomes on-state and the NMOS 14 becomes off-state, so that a high-level signal will be output from the output terminal OUT.

Consequently, according to the circuit structure as shown in Fig. 1 there will be output from the output terminal OUT a signal that is inverted with respect to the signal input to the input terminal IN, due to the action described in the above.

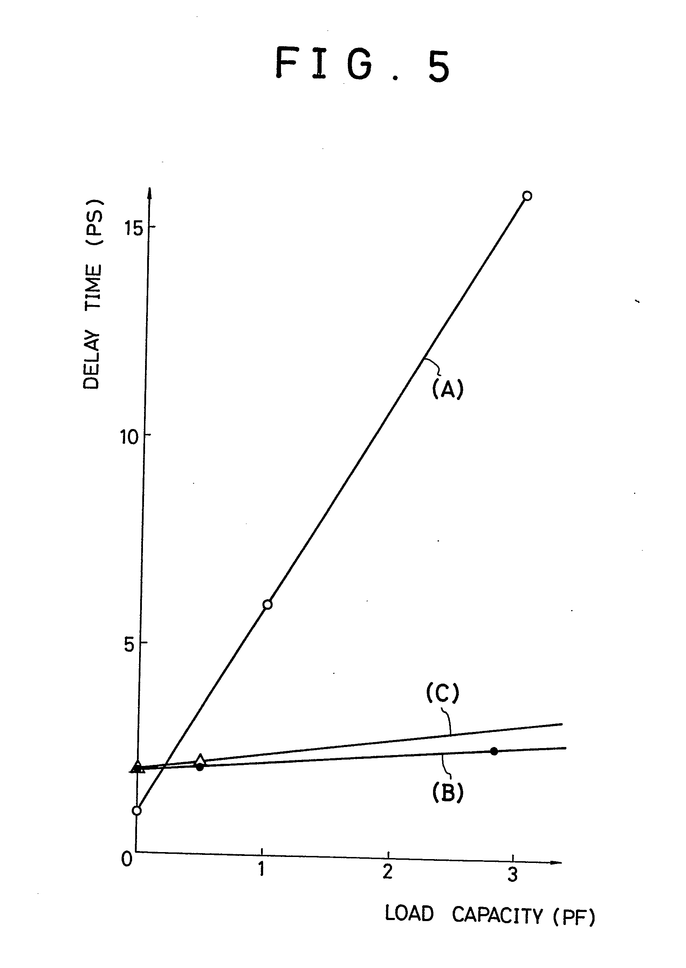

Now, ordinarily, various kinds of circuits are connected to the output of the inverter circuit. In such a case, if the load that is connected to the circuit is high, the rise and fall times of the output signal tend to be increased as shown by the curve (A) of Fig. 5. Namely, in the prior invester circuit there exists a dependency of the rise and fall times of the output signal on the capacity of the load, giving rise to a fear of hindering desired fast operation if the load capacity is too large. As a counter measure against such a situation, the following arrangement is introduced to the prior inverter circuit as shown in Fig. 1. Namely, a fast operation is arranged to be performed by suppressing the increase in the rise and fall times of the output signal through enhancement of the current driving capability by constructing both of the MOS transistors 12 and 14 large in size. However, such a countermeasure reverses the current trend, in particular in view of the effort for miniaturizing the inverter circuit by means of integration of the circuit. Therefore, an improvement over the countermeasure has been desired earnestly.

## SUMMARY OF THE INVENTION

An object of the present invention is to provide a logic circuit which permits to improve the fast operational characteristics of a load that is connected to its output terminal.

Another object of the present invention is to provide a logic circuit which reduces the load capacity dependency of the rise and fall times of the output signal by miniaturizing its construction.

A special feature of the present invention is that a logic circuit that is composed of MOS transistors comprises a first inversion circuit for inverting the signal that is input to the

- 3 -

0196616

input terminal, a second inversion circuit composed of a MOS transistor for inverting the signal that was inverted by the first inversion circuit, a first NPN bipolar transistor whose base is connected to either of the first invension circuit and the second inversion circuit, whose collector is connected to a power source, and whose emitter is connected to the output terminal of the signal, and a second NPN bipolar transistor whose base is connected to the other of the first inversion circuit and the second inversion circuit, whose collector is connected to the power source, and whose emitter is connected to the ground.

These and other objects, features, and advantages of the present invention will be more apparent from the following discription of the preferred embodiments, taken in conjunction with the accompanying drawings.

## BRIEF DESCRIPTION OF THE DRAWINGS

Fig. 1 is a circuit diagram for a prior inverter circuit;

Fig. 2 is a circuit diagram for an inverter circuit embodying the present invention;

Fig. 3 is a circuit diagram for a second embodiment of the inverter circuit in accordance with the present invention;

Fig. 4 is a circuit diagram for a third embodiment of the inverter circuit in accordance with the present invention; and

Fig. 5 is a graph for showing the changes in the rise and fall times of the output signal versus the load capacity, for each of the prior example shown in Fig. 1 and the embodiments shown in Figs. 2 and 3.

## DESCRIPTION OF THE PREFERRED EMBODIMENTS

Referring to Fig. 2, an inversion circuit which is embodying the present invention is shown with reference numeral 20. The inversion circuit 20 comprises a first inverted output unit 22, a second inverted output unit 24 which receives the inverted signal output from the first inverted output unit 22, and inverts the inverted signal once again, and an output unit 26 that forms the output stage of the inverter circuit. The first inverted output unit 22 consists of a first P-channel MOS transistor (referred to as "first PMOS" hereafter) 28 and a first N-channel MOS transistor (referred to as "first NMOS" hereafter) 30. The gate terminals of the first PMOS 28 and the first NMOS 30 are connected to the input terminal IN, and their respective drain terminals are connected to each other. Further, the source terminal of the first PMOS 28 is connected to a voltage source $V_{DD}$ 32, while the source terminal of the first NMOS 30 is connected to a $V_{SS}$ terminal 34 to which is supplied a potential of, for instance, OV.

The second inverted output unit 24 consists of a second P-channel MOS transistor (referred to as "second PMOS" hereafter) 36 and a second N-channel MOS transistor (referred to as "second NMOS" hereafter) 38. The gate terminals of the second PMOS 36 and the second NMOS 38 are connected to the drain terminals of the first PMOS 28 and the first NMOS 30, the drain terminals of the second PMOS 36 and the second NMOS 38 are connected each other, the source terminal of the second PMOS 36 is connected to the voltage source $V_{DD}$ 32, and the source terminal of the second NMOS 38 is connected to the $V_{SS}$ terminal 34.

The output stage 26 that is connected in the so-called totem pole manner consists of a first NPN bipolar transistor (referred to as "first NPN" hereafter) 42 and a second NPN bipolar transistor (referred to as "second NPN" hereafter) 44. The base terminal of the first NPN 42 is connected to the drain terminals of the first PMOS 28 and the first NMOS 30, its emitter terminal is connected to the output terminal OUT that outputs a signal which is the inversion of the signal input to the input terminal IN, and its collector terminal is connected to the voltage source $V_{DD}$ 32. Further, the base terminal of the second NPN 44 is connected to the drain terminals of the second PMOS 36 and the second NMOS 38, its emitter terminal is connected to the output terminal OUT, and its emitter terminal is connected to the $V_{SS}$ terminal 34.

Next, the operation of the first embodiment will be described.

First, description will be given about the case in which the state of the signal that is input to the input terminal IN changes from the low level (referred to as "L" level, hereafter) to the high level (referred to as "H" level, hereafter). Here, it will be assumed that prior to the above change in the signal state, the first NPN 42 is in on-state, the second NPN 44 is in off-state, and the output terminal OUT is on "H" level due to the feeding from the voltage source $V_{DD}$ 32.

When the state of the signal that is input to the input terminal IN becomes "H" level, this "H" level signal is supplied to the gate terminals of the first PMOS 28 and the first NMOS 30, causing the PMOS 28 change from on-state to off-state and the NMOS 30 from off-state to on-state. Accordingly, on "L" level signal output from the first inverted output unit 22 is supplied to the base terminal of the first NPN 42, and to the gate terminals of the second PMOS 36 and the second NMOS 38 that constitute the second inverted output unit 24. Upon receipt of the "L" level signal, the second PMOS 36 changes from off-state to on-state, and further, the second NMOS 38 changes from on-state to off-state. As a result, as the output of the second inverted output unit 24, a "H" level signal is supplied to the base terminal of the second NPN 44. Therefore, the first NPN 42 goes from on-state to off-state, while the second NPN 44 shifts from off-state to on-state. As a result, the electrical changes that were accumulated during the time when the output terminal OUT was on "H" level, in a load capacitor (not shown) that is connected to the output terminal OUT, flows into the $V_{SS}$ terminal 34 via the second NPN 44, bringing the output terminal OUT to "L" level.

Next, the case in which the signal input to the input terminal IN changes from "H" level to "L" level, under a state where the output terminal OUT is on "L" level, will be described. This "L" level signal is supplied then to the gate terminals of the first PMOS 28 and the first NMOS 30, which causes the PMOS 28 to shift from off-state to on-state, and NMOS 30 from on-state to off-state. Consequently, on "H" level signal as the output of the first inverted output unit 22 is supplied to the base terminal of the first NPN 42, and to the gate terminals of the second PMOS 36 and the second NMOS 38 that constitute the second inverted output unit 24. Upon receipt of the "H" level signal, the second PMOS 36 changes from on-state to off-state, and further, the second NMOS 38 changes from off-state to on-state. Accordingly, as the output of the second inverted output unit 24, on "L" level signal is supplied to the base terminal of the second NPN 44. Therefore, the first NPN 42 changes from off-state to on-state and the second NPN 44 changes from on-state to off-state. As a result, a current flows from the voltage source $V_{DD}$ 32 to the load capacitor via the first NPN 42 to charge the load capacitor, bringing the output terminal OUT to on "H" level state.

Now, the result of simulation for the change in the mean value of the rise time of the output signal (time required for changing the output voltage from 10% to 90%) and the fall time of the output signal (time required for changing the output voltage from 90% to 10%) versus the increase in the load capacity that is connected to the output terminal OUT of the inverter circuit according to the first embodiment is shown by curve (B) of Fig. 5. As may be seen, the rate of change is reduced sharply in comparison to the rate of change for the prior inverter circuit (B). This shows that the dependency on the load capacity of the rise and fall times of the output signal can be improved substantially.

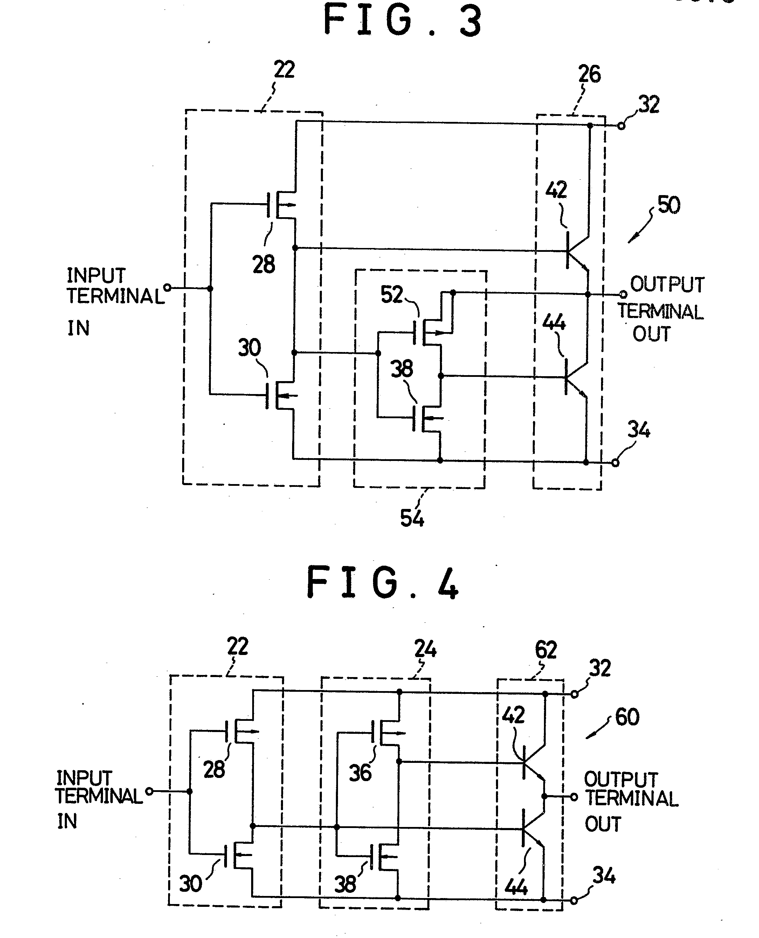

Referring to Fig. 3, a second embodiment of the inverter circuit in accordance with the present invention is shown with reference numeral 50.

The inverter circuit 50 of the second embodiment has the

0196616

same construction as the inverter circuit shown in Fig. 2, except that a second inverted output unit 54 is constructed by providing a second PMOS 52 whose gate terminal is connected to the drain terminals of the PMOS 28 and the NMOS 30, whose drain terminal is connected to the drain terminal of the NMOS 38, and whose source terminal and the substrate are connected to the output terminal OUT, instead of the second PMOS 36 of the second inverted output unit 24 in the first embodiment.

Now, with the circuit construction shown in Fig. 2, when the gate terminal of the second PMOS 36 becomes "L" level and the PMOS 36 is found in on-state, current continues to flow from the voltage source $V_{DD}$ 32 to the base terminal of the second NPN 44 via the PMOS 36, as long as this state persists. Therefore, with the above construction, even when the gate terminal of the PMOS 52 is on "L" level and the PMOS 52 is in on-state, the current will cease to flow between the source and drain of the PMOS 52 as soon as the charges accumulated in the load capacitor (not shown) that is connected to the output terminal OUT is exhausted. Therefore, it becomes possible to reduce the power consumption composed with the inverter circuit shown in Fig. 2 Moreover, it becomes also possible to improve the dependency on the load capacity of the rise and fall times of the output signal, as may be seen from curve (C) of Fig. 5. Furthermore, items with the same symbols as in Fig. 2 indicate identical components, and their description is omitted.

Referring to Fig. 4, a third embodiment of the inverter circuit in accordance with the present invention is shown with reference numeral 60. In the third embodiment of the inverter circuit 60, the output stage 62 is constructed by connecting the base terminal of the first NPN 42 in the first embodiment to the drain terminal of the second PMOS 36 and the second NMOS 38, and by connecting the base terminal of the second NPN 44 to the drain terminals of the first PMOS 28 and the first NMOS 30.

Therefore, a signal that is input to the input terminal IN is supplied to the base terminal of the first NPN 42 via the first inverted output unit 22 and the second inverted output unit 24. That is, when the input signal is an "L" level signal, the base terminal of the first NPN 42 becomes "L" level. Further, the input signal is supplied to the base terminal of the second NPN 44 via the first inverted output unit 22, so that when the input signal is on "L" level, the base terminal of the second NPN 44 will become an "H" level signal.

With such a construction, when an "L" level signal is input to the input terminal IN, the base terminal of the first NPN 42 will be on "L" level, and the first NPN 42 will be in off-state. Further, the base terminal of the second NPN 44 will be on "H" level, and the second NPN 44 will be in on-state, so that there will be output an "L" level signal from the output terminal OUT. On the contrary, when an "H" level signal is input to the input terminal IN, the base terminal of the first NPN 42 will be on "H" level, a the first NPN 42 will be in on-state. Further, the base terminal of the second NPN 44 will be on "L" level, and the second NPN 44 will be in off-state, so that an "H" level signal will be output from the output terminal OUT, performing the buffer operation.

Therefore, it becomes possible to realize with ease a buffer circuit that possesses the same effects as the inverter circuit, from the inverter circuit shown in Fig. 2. It should be mentioned that components that carry same symbols as in Fig. 2 designate identical items, and their description was omitted.

In summary, according to the present invention, the output stage of the logic circuit is constructed by connecting bipolar transistors that possess higher current driving capability than the MOS transistors in the so-called totem pole fashion. Moreover, a control unit composed of transistors is provided for carrying out fast switching operation of the bipolar transistors. Therefore, it becomes possible to reduce the load capacity dependence of the rise and fall times of the output signal, and to provide a logic circuit that can carry out fast operation even under condition of high load capacity.

0196616

Various modifications will become possible for those skilled in the art after receiving the teachings of the present disclosure without departing from the scope thereof.

CLAIMS:

1. A logic circuit comprising:

a first inverter circuit (22) for inverting a signal that is inputted to its input terminal;

a second inverter circuit (24) for inverting the signal that is inverted by said first inverter circuit;

a first type first bipolar transistor (42) whose base is connected to either of said first inverter circuit and said second inversion circuit, whose collector is connected to a first power supply terminal (32), and whose emitter is connected to the output terminal of the logic circuit;

and a first type second bipolar transistor (44) whose base is connected to the other of the first inversion circuit and the second inverter circuit, whose collector is connected to the output terminal, and whose emitter is connected to a second power supply terminal (34).

2. A logic circuit as claimed in claim 1, wherein a first inverter circuit (22) has first type (28) and second type (30) MOS transistors, each gate of which is connected in parallel to an input terminal (IN) of the logic circuit, and each drain of which is connected in parallel to each other as an output terminal thereof.

3. A logic circuit as claimed in claim 2, wherein a second inverter circuit (24) has first type (36) and second type (38) MOS transistors, each gate of which is connected in parallel to the output terminal of said first inverter circuit, each drain of which is connected in parallel to each other as an output terminal of the second inverter circuit.

4. A logic circuit as claimed in claim 3, wherein the base of the first type first bipolar transistor (42) is connected to the gate of the first type MOS transistor of the second inverter circuit, the base of the first type second bipolar transistor (44) is connected to the output terminal of the second inverter circuit, the emitter of the first type first bipolar transistor (42) and the collector of the first type second bipolar transistor (44) are connected in parallel to each other so as to form an output terminal of the logic circuit; at least the source of the first type MOS transistor of the first inverter circuit and the collector of the first type first bipolar transistor (42) being connected in parallel to a first power supply terminal (32) while the sources of the second MOS transistors of the first and second inverter circuit and the emitter of the first type second bipolar transistor (44) being connected in parallel to a second power supply terminal (34).

5. A logic circuit as claimed in claim 4, wherein said first type MOS transistors (28, 36) of the first and second inverter circuits are P type MOS transistors, said second type MOS transistors (30, 38) of the first and second inverter circuit are N type MOS transistors, and the first and second bipolar transistors (42, 44) are NPN bipolar transistors.

6. A logic circuit as claimed in claim 4, wherein said first type MOS transistors (28, 36) of the first and second inverter circuits are N type MOS transistors, said second type MOS transistors (30, 38) thereof are P type MOS transistors, and the first and second bipolar transistors (42, 44) are PNP bipolar transistors.

7. A logic circuit as claimed in claim 4, wherein the source of the first type MOS transistor of the second inverter circuit is connected in parallel to the source of said first MOS transistor of the first inverter circuit, thereby producing from the output terminal of the third inverter circuit as inverted output signal to an input signal.

- 12 -

0196616

8.   A logic circuit as claimed in claim 4, wherein the source and the second gate of the first type first MOS transistor of the second inverter circuit are connected in parallel to the junction point of the emitter and the collector of the bipolar transistors of the third inverter circuit, thus reducing power consumption by blocking the current flowing between the source and drain of the first MOS transistor in the second inverter circuit even when the first MOS transistor of the second inverter circuit is in the ON condition.

9.   A logic circuit as claimed in claim 3, wherein the gate of the first type first bipolar transistor (42) is connected to the output terminal of the second circuit, and the gate of the first type second bipolar transistor (44) is connected to the output terminal of the drains of the first and second type MOS transistors of the first inverter circuit, thereby producing from the output terminal (OUT) of the logic circuit a non-inverted output signal to an input signal applied to the input terminal (IN) of the first inverter circuit.

10.   A logic circuit as claimed in claim 9, wherein said first type MOS transistors (28, 36) in the first and second circuit are the P type MOS transistors, said second type MOS transistors (30, 38) in the first and second circuit are N type MOS transistors, and the first type bipolar transistors are NPN bipolar transistors.

11.   A logic circuit as claimed in claim 9, wherein said first type MOS transistors (28, 36) in the first and second circuit are N type MOS transistors, the second type MOS transistors (30, 38) in the first and second circuit are P type MOS transistors, and the first type bipolar transistors are PNP type bipolar transistors, respectively.

12. A logic circuitry which comprising:

a first inverter circuit (22) having first type (28) and second type (30) MOS transistors, each gate of which is connected in parallel to an input terminal (IN) of the logic circuitry, and each drain of which is connected in parallel to each other as an output terminal thereof;

a second inverter circuit (24) having first type (36) and second type (38) MOS transistors, each gate of which is connected in parallel to the output terminal of said first inverter circuit, each drain of which is connected in parallel to each other as an output terminal of the second inverter circuit; and

a third inverter circuit (26) having first and second first type bipolar transistors (42, 44), the base of the first bipolar transistor (42) of the third inverter circuit is connected to the gate of the first type MOS transistor of the second inverter circuit, the base of the second bipolar transistor (44) of the third inverter circuit is connected to the output terminal of the second inverter circuit, the emitter of the first bipolar transistor (42) and the collector of the second bipolar transistor (44) of the third inverter circuit are connected in parallel to each other so as to form an output terminal of the logic circuitry; at least the source of the first type MOS transistor of the first inverter circuit and the collector of the first bipolar transistor (42) of the third inverter circuit being connected in parallel to a first power supply terminal (32) while the sources of the second MOS transistors of the first and second inverter circuit and the emitter of the second bipolar transistor (44) of the third inverter circuit being connected in parallel to a second power supply terminal (34).

13. A logic circuitry which comprising:

a first inverter circuit (22) having first type (28) and second type (30) MOS transistors, each gate of which is connected in parallel to each other to an input terminal (IN) of the logic circuitry, and each drain of which is connected in parallel to each other as an output terminal thereof;

a second circuit (24) having first type (36) and second type (38) MOS transistors, each gate of which is connected in parallel to the output terminal (OUT) of the first inverter circuit, each drain of which is connected in parallel to each other; and

a third inverter circuit (62) having first type bipolar transistors (42, 44), the gate of the first bipolar transistor (42) of the third inverter circuit is connected to the output terminal of the second circuit, and the gate of the second bipolar transistor (44) of the third inverter circuit is connected to the output terminal of the drains of the first and second type MOS transistors of the first inverter circuit, thereby producing from the output terminal (OUT) of the third inverter circuit a non-inverted output signal to an input signal applied to the input terminal (IN) of the first inverter circuit.

# F I G . 1

INPUT TERMINAL

# F I G . 2

INPUT TERMINAL IN

# FIG. 3

INPUT
TERMINAL
IN

OUTPUT
TERMINAL
OUT

22 28 30 52 38 26 42 44 50 32 34 54

# FIG. 4

INPUT
TERMINAL
IN

OUTPUT
TERMINAL
OUT

22 28 30 24 36 38 62 42 44 60 32 34

# FIG. 5